# EUROPEAN PATENT APPLICATION

(11) **EP 4 618 398 A1**
(43) Date of publication of application: **17.09.2025**
(21) Application number: 24763856.2
(22) Date of filing: 26.02.2024
(51) Int. Cl.: H02M 7/48, H01L 25/07, H01L 25/18

(54) **POWER SEMICONDUCTOR MODULE AND ELECTRIC POWER CONVERSION APPARATUS**

(30) Priority: 01.03.2023 JP 2023030765
(71) Applicant: IHI Corporation, Tokyo 135-8710 (JP)
(72) Inventor: NOTAKE Koki, Tokyo 135-8710 (JP)
(74) Representative: TBK
(86) International application number: PCT/JP2024/006866
(87) International publication number: WO 2024/181376

(57) **Abstract**

A power semiconductor module includes: a power semiconductor element configured to switch conduction and non-conduction between a first electrode and a second electrode according to a control signal applied to a control electrode; a heat sink capable of dissipating heat from the power semiconductor element; a first power line part and a second power line part configured to transmit electric power between the first electrode and the second electrode; a first control line part configured to apply the control signal to the control electrode; and a second control line part configured to provide a reference potential of the control signal. The heat sink includes a shielding layer formed from a material having at least one of electrical conductivity and magnetism. The heat sink includes at least one through hole passing from a front surface to a rear surface. Only the first control line part and the second control line part among the first power line part, the second power line part, the first control line part, and the second control line part extend to a region on the rear surface of the heat sink through the through hole.

## Description

### Technical Field

The present disclosure relates to a power semiconductor module and an electric power conversion apparatus.

### Background Art

Patent Literatures 1 to 8 disclose technology relating to a power semiconductor module used for electric power conversion apparatuses and the like. For example, Patent Literature 1 discloses a module element forming an inverter bridge. In this module element, a transistor pellet is housed inside a container formed of a copper base and a cover. The transistor pellet is placed on the copper base via an insulating layer of ceramic and a copper material. A collector terminal, an emitter terminal, and a gate terminal are electrically connected, respectively, to a collector electrode, an emitter electrode, and a gate electrode of the transistor pellet via wire bonding or the like. These terminals extend to the outside of the container together from the upper cover.

### Citation List

### Patent Literature

[Patent Literature 1] Japanese Unexamined Patent Publication No. H3-214657
[Patent Literature 2] Japanese Unexamined Patent Publication No. 2004-039749
[Patent Literature 3] Japanese Unexamined Patent Publication No. 2009-105178
[Patent Literature 4] Japanese Unexamined Patent Publication No. 2005-183776
[Patent Literature 5] Japanese Patent No. 2001-185679
[Patent Literature 6] Japanese Unexamined Patent Publication No. 2006-191765
[Patent Literature 7] Japanese Unexamined Patent Publication No. 2007-335808
[Patent Literature 8] Japanese Unexamined Patent Publication No. 2021-150451

### Summary of Invention

### Technical Problem

The output voltage required for such electric power conversion apparatuses as mentioned above is increasingly rising. With the increase in the output voltage, the voltage applied to the collector electrode and a source electrode of the module element also increases. As a result, radiated noise (electromagnetic noise) emitted from wires and the like connected to the collector electrode and the source electrode also increases. In contrast, the gate voltage input to the gate electrode is extremely low compared to the high voltage applied to the collector electrode and the source electrode. Thus, when large radiated noise from the wires and the like of the collector electrode and the source electrode propagates to the gate electrode, the gate voltage may vary greatly due to the influence of the radiated noise. Such variation in the gate voltage may cause operational failures such as the occurrence of malfunctions in the module element.

The present disclosure describes a power semiconductor module and an electric power conversion apparatus which are capable of suppressing the occurrence of operational failures caused by radiated noise.

### Solution to Problem

A power semiconductor module according to an embodiment of the present disclosure includes: a power semiconductor element including a first electrode, a second electrode, and a control electrode, and configured to alternately switch conduction and non-conduction between the first electrode and the second electrode according to a control signal applied to the control electrode; a heat sink including a front surface on which the power semiconductor element is installed and a rear surface opposite the front surface, and capable of dissipating heat from the power semiconductor element; a first power line part and a second power line part electrically connected to the first electrode and the second electrode, respectively, and configured to transmit electric power between the first electrode and the second electrode; a first control line part electrically connected to the control electrode and configured to apply the control signal to the control electrode; and a second control line part electrically connected to the second electrode and configured to provide a reference potential of the control signal. The heat sink includes a shielding layer formed from a material having at least one of electrical conductivity and magnetism. The heat sink includes at least one through hole passing from the front surface to the rear surface. Only the first control line part and the second control line part among the first power line part, the second power line part, the first control line part, and the second control line part extend to a region on the rear surface of the heat sink through the through hole.

### Advantageous Effects of Invention

The present disclosure provides a power semiconductor module and an electric power conversion apparatus which are capable of suppressing the occurrence of operational failures caused by radiated noise.

### Brief Description of Drawings

FIG. 1 is a circuit diagram illustrating an electric power conversion apparatus of an embodiment.
FIG. 2 is a cross-sectional view illustrating a power semiconductor module of the electric power conversion apparatus of FIG. 1.
FIG. 3 is a plan view of a power semiconductor element of the power semiconductor module of FIG. 2 viewed from above.
FIG. 4 is a simplified cross-sectional view illustrating a power semiconductor module of a comparative example.
FIG. 5 is a simplified cross-sectional view illustrating the power semiconductor module of FIG. 2.
FIG. 6 is a cross-sectional view illustrating a power semiconductor module of Variation 1.
FIG. 7 is a simplified cross-sectional view illustrating a power semiconductor module of Variation 2.
FIG. 8 is a plan view of the power semiconductor element of FIG. 7 viewed from above.
FIG. 9 is a simplified cross-sectional view illustrating a power semiconductor module of Variation 3.
FIG. 10 is a simplified cross-sectional view illustrating a power semiconductor module of Variation 4.
FIG. 11 is a simplified cross-sectional view illustrating a power semiconductor module of Variation 5.
FIG. 12 is a simplified cross-sectional view illustrating a power semiconductor module of Variation 6.

### Description of Embodiments

A power semiconductor module according to an embodiment of the present disclosure includes: a power semiconductor element including a first electrode, a second electrode, and a control electrode, and configured to alternately switch conduction and non-conduction between the first electrode and the second electrode according to a control signal applied to the control electrode; a heat sink including a front surface on which the power semiconductor element is installed and a rear surface opposite the front surface, and capable of dissipating heat from the power semiconductor element; a first power line part and a second power line part electrically connected to the first electrode and the second electrode, respectively, and configured to transmit electric power between the first electrode and the second electrode; a first control line part electrically connected to the control electrode and configured to apply the control signal to the control electrode; and a second control line part electrically connected to the second electrode and configured to provide a reference potential of the control signal. The heat sink includes a shielding layer formed from a material having at least one of electrical conductivity and magnetism. The heat sink includes at least one through hole passing from the front surface to the rear surface. Only the first control line part and the second control line part among the first power line part, the second power line part, the first control line part, and the second control line part extend to a region on the rear surface of the heat sink through the through hole.

In the power semiconductor module, conduction and non-conduction between the first electrode and the second electrode are alternately switched according to the control signal input to the control electrode. High electric power is applied to the first electrode and the second electrode in a conduction state. Accordingly, large radiated noise is emitted from the first electrode and the second electrode. In the power semiconductor module, only the first control line part and the second control line part among the first power line part, the second power line part, the first control line part, and the second control line part extend to the region on the rear surface of the heat sink through the at least one through hole in the heat sink. Furthermore, the heat sink includes the shielding layer formed from a material having at least one of electrical conductivity and magnetism. The radiated noise emitted from the first power line part and the second power line part can thus be shielded by the heat sink. Consequently, in the power semiconductor module, the first power line part and the second power line part on the front surface of the heat sink and the first control line part and the second control line part in the region on the rear surface of the heat sink are separated by the heat sink. Thus, propagation of the radiated noise from the first power line part and the second power line part to the first control line part and the second control line part through the heat sink is suppressed. In this manner, using the heat sink as a shielding plate that shields the radiated noise makes it possible to suppress the propagation of large radiated noise from the first power line part and the second power line part to the first control line part and the second control line part. This makes it possible to suppress large variations in the control signal due to the influence of the radiated noise. As a result, the occurrence of operational failures such as malfunctions in the power semiconductor element caused by variations in the control signal can be suppressed.

In some embodiments, the first control line part may include a first monotonically increasing region extending from a cross-section of the through hole, a distance between the first monotonically increasing region and the first power line part and second power line part increasing monotonically in a direction from the control electrode toward the through hole. The second control line part may include a second monotonically increasing region extending from a cross-section of the through hole, a distance between the second monotonically increasing region and the first power line part and second power line part increasing monotonically in a direction from the second electrode toward the through hole.

In some embodiments, the power semiconductor module may include a cover covering the front surface of the heat sink on which the power semiconductor element is placed. The first power line part and the second power line part may extend toward the cover from the first electrode and the second electrode, and may extend to an outside of a region covered by the cover through the cover. The cover may include a side wall and a top plate facing the front surface with the side wall interposed therebetween. The first power line part and the second power line part may extend toward the top plate from the first electrode and the second electrode, and may extend to the outside of the region covered by the cover through the top plate. In such configuration, the first control line part and the second control line part can extend to a side opposite the first power line part and the second power line part, so that the propagation of the radiated noise from the first power line part and the second power line part to the first control line part and the second control line part can be more effectively suppressed.

In some embodiments, the first electrode may be disposed to face the front surface. The second electrode and the control electrode may be disposed on a side of the first electrode opposite to the front surface. The at least one through hole may be formed at a position not overlapping the second electrode and the control electrode in plan view of the heat sink. In this case, the configuration in which the first control line part and the second control line part extend to the region on the rear surface of the heat sink through the through hole can be easily achieved.

In some embodiments, the second electrode and the control electrode may be disposed to face the front surface. The first electrode may be disposed on a side of the second electrode and the control electrode opposite to the front surface. The at least one through hole may be formed at a position overlapping the second electrode and the control electrode in plan view of the heat sink. In this case, the distance from a gate electrode and a source electrode to the through hole can be kept as short as possible, so that the portions of the first control line part and the second control line part exposed inside a casing where the radiated noise may propagate can be kept as small as possible. This can reduce the risk of the radiated noise propagating to the first control line part and the second control line part inside the casing.

In some embodiments, the heat sink may include one through hole. The first control line part and the second control line part may extend to the region on the rear surface through the one through hole. In this manner, in the case in which the first control line part and the second control line part are passed through the one through hole together, the distance between the first control line part and the second control line part becomes shorter, and accordingly, the area of a loop formed by the first control line part and the second control line part becomes smaller. If the area of the loop is reduced in this manner, the electromotive force that is generated when electromagnetic waves (radiated noise) intersect the loop can be reduced. This can reduce the risk of large conductive noise being generated in the first control line part and the second control line part.

In some embodiments, the first control line part and the second control line part may be twisted together and extend to the region on the rear surface through the one through hole. In this case, even if the radiated noise from the first power line part and the second power line part propagates to the first control line part and the second control line part, the conductive noise generated in the first control line part and the second control line part and the conductive noise generated in the twisted portion therebeyond will act to cancel each other out. Thus, the risk of large conductive noise being generated in the first control line part and the second control line part can be reduced.

In some embodiments, the power semiconductor module may further include a tubular electromagnetic shield disposed to surround the first control line part and the second control line part between the second electrode and control electrode and an opening of the one through hole on the front surface, and including a shielding layer formed from a material having at least one of electrical conductivity and magnetism. In this case, the radiated noise from the first power line part and the second power line part can be shielded by the electromagnetic shield, so that the propagation of the radiated noise to the first control line part and the second control line part inside the electromagnetic shield can be suppressed.

In some embodiments, the first control line part and the second control line part may include a common mode filter or a transformer capable of removing a common mode component of conductive noise conducted through the first control line part and the second control line part. The common mode filter or the transformer may be disposed inside the one through hole. In this case, the common mode component of the conductive noise that may be generated in the first control line part and the second control line part can be removed, so that variations in the control signal caused by the common mode component can be suppressed. Furthermore, the propagation of the radiated noise from the first power line part and the second power line part to the first control line part and the second control line part through the common mode filter or the transformer can be suppressed by the common mode filter or the transformer being disposed inside the through hole.

In some embodiments, the heat sink may include, as the through hole, a first through hole and a second through hole formed at different positions on the front surface. The first control line part may extend to the region on the rear surface through the first through hole. The second control line part may extend to the region on the rear surface through the second through hole. In this case, the first control line part and the second control line part can reach the first through hole and the second through hole, respectively, by the shortest distance. This enables the portions of the first control line part and the second control line part exposed inside the casing where the radiated noise may propagate to be kept as small as possible, thereby reducing the risk of the radiated noise propagating to the first control line part and the second control line part inside the casing.

A power conversion apparatus according to an embodiment of the present disclosure includes: a power conversion part including any one of the power semiconductor modules described above, and configured to convert a first mode of electric power provided by a power source into a second mode of electric power required by a load device; and a control part configured to transmit the control signal to the power semiconductor module. This power conversion apparatus includes any one of the power semiconductor modules described above, so that the occurrence of operational failures such as malfunctions in the power semiconductor element caused by variations in the control signal can be suppressed as described above.

A semiconductor unit and an electric power conversion apparatus of the present disclosure will be described in detail below with reference to the accompanying drawings. Same reference signs will be given to the same elements in the description of the drawings, and redundant explanation will be omitted.

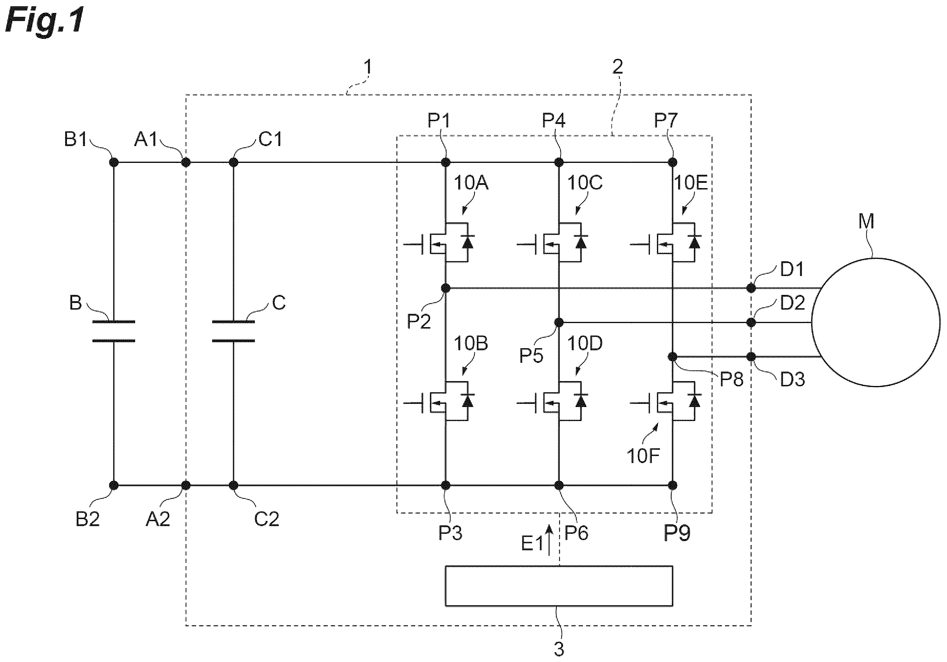

An electric power conversion apparatus 1 illustrated in FIG. 1 converts electric power received from a power source B into electric power required by a load device M. The power source B outputs, for example, direct current power. The power source B has a power source positive terminal B1 and a power source negative terminal B2. The load device M is, for example, a three-phase alternating current motor. The three-phase alternating current motor may be used as a drive source for rotating an impeller. The electric power conversion apparatus 1 may be employed as an electrical component of an electric compressor, an electric blower, or the like. The electric compressor may be mounted in a moving body such as a vehicle.

The electric power conversion apparatus 1 of the present embodiment converts direct current power into alternating current power. That is, in the present embodiment, direct current power is exemplified as a first mode of electric power and alternating current power is exemplified as a second mode of electric power. The electric power conversion apparatus 1 may be an inverter in a narrow sense. The electric power conversion apparatus 1 may convert alternating current power into direct current power. That is, the electric power conversion apparatus 1 may be a converter. The electric power conversion apparatus 1 may convert direct current power of a first mode into direct current power of a second mode.

The electric power conversion apparatus 1 has a positive terminal A1 and a negative terminal A2 as input terminals. The positive terminal A1 is connected to the power source positive terminal B1. The negative terminal A2 is connected to the power source negative terminal B2. The electric power conversion apparatus 1 has an output terminal D1, an output terminal D2, and an output terminal D3 as output terminals. These output terminals D1, D2, and D3 are connected to the load device M. For example, the output terminals D1, D2, and D3 correspond, respectively, to a U-phase, a V-phase, and a W-phase of a three-phase alternating current motor.

The electric power conversion apparatus 1 has a capacitor C and a switching circuit 2 (power conversion part) as electrical components. The capacitor C is connected between the power source B and the load device M. The capacitor C is, for example, a direct current capacitor. A positive terminal C1 of the capacitor C is connected to the power source positive terminal B1. A negative terminal C2 of the capacitor C is connected to the power source negative terminal B2. The switching circuit 2 is connected between the capacitor C and the load device M. The switching circuit 2 converts direct current power into pseudo alternating current power. The switching circuit 2 includes power semiconductor elements 10A to 10F as switches and connecting points P1 to P9.

The connecting points P1, P4, and P7 are connected to the positive terminal C1 of the capacitor C. The connecting points P3, P6, and P9 are connected to the negative terminal C2 of the capacitor C. The connecting points P2, P5, and P8 are connected to the output terminals D1, D2, and D3, respectively. The power semiconductor element 10A is connected to the connecting points P1 and P2. The power semiconductor element 10B is connected to the connecting points P2 and P3. The connecting points P1, P2, and P3 and the power semiconductor elements 10A and 10B form a first leg. Similarly, the connecting points P4, P5, and P6 and the power semiconductor elements 10C and 10D form a second leg. The connecting points P7, P8, and P9 and the power semiconductor elements 10E and 10F form a third leg.

Each of the power semiconductor elements 10A to 10F is a semiconductor switch such as a Metal Oxide Semiconductor Field Effect Transistor (MOSFET) or an Insulated Gate Bipolar Transistor (IGBT). The power semiconductor elements 10A to 10F are electrically connected to a control board 3 (control part). The power semiconductor elements 10A to 10F switch on or off in accordance with a control signal E1 output from the control board 3. The control board 3 is formed of a computer including, for example, a CPU, a ROM, and a RAM. When describing the power semiconductor elements 10A to 10F without distinguishing between them individually, the power semiconductor elements 10A to 10F are referred to simply as a "power semiconductor element 10."

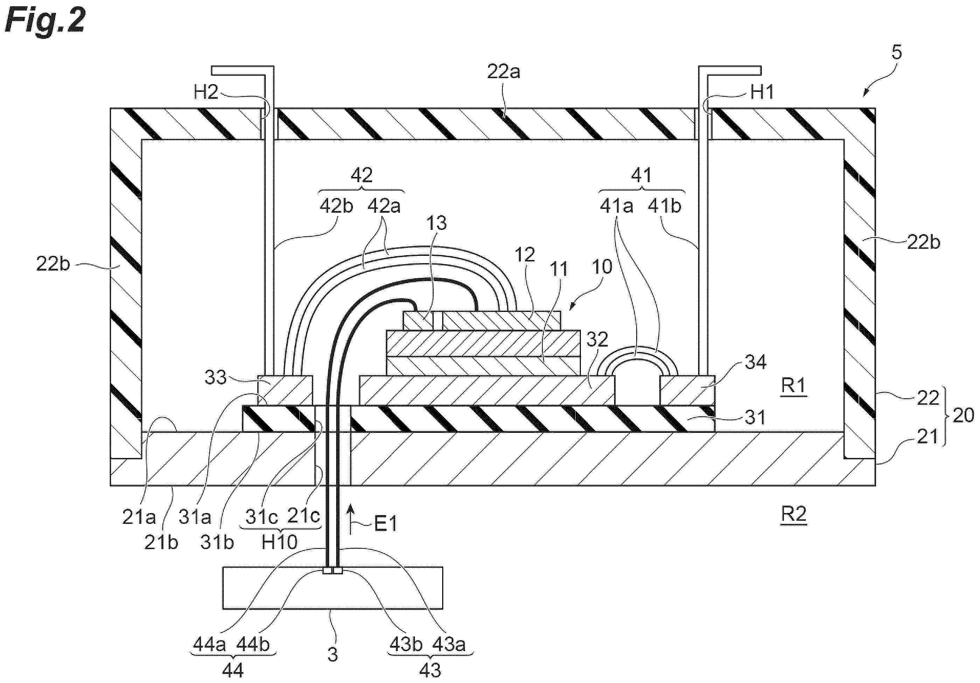

As illustrated in FIG. 2, the power semiconductor element 10 is housed inside a casing 20. The power semiconductor element 10 and the casing 20 form a power semiconductor module 5. The present embodiment exemplifies a case in which the six power semiconductor elements 10A to 10F are all housed in one casing 20. However, for example, an aspect in which one power semiconductor element is housed in each of six casings (i.e., an aspect in which one power semiconductor element is housed in each casing) is also acceptable. An aspect in which two power semiconductor elements are housed in each of three casings (i.e., an aspect in which two power semiconductor elements are housed in each casing) is also acceptable, and other aspects may also be used. As illustrated in FIG. 2, the casing 20 has a heat sink 21 on which the power semiconductor element 10 is installed, and a cover 22 that covers the power semiconductor element 10. The heat sink 21 is, for example, a plate-like member formed including a material having thermal conductivity capable of dissipating heat from the power semiconductor element 10. The material having thermal conductivity capable of dissipating heat from the power semiconductor element 10 may be, for example, a material having low thermal resistance capable of transferring heat from the power semiconductor element 10 to other components. The heat sink 21 is a metal plate formed from a metal material such as copper.

Such a metal material has conductivity (i.e., electrical conductivity) capable of shielding radiated noise. Accordingly, the heat sink 21 also functions as a shielding plate for shielding radiated noise. Radiated noise is electromagnetic noise in which electric fields and magnetic fields alternately intertwine and propagate through space. Radiated noise is generated, for example, along with the switching operation of the power semiconductor element 10. That the heat sink 21 is capable of shielding radiated noise means that the heat sink 21 has the function to prevent or suppress passage of the radiated noise through the heat sink 21. In this manner, the heat sink 21 has thermal conductivity capable of dissipating heat from the power semiconductor element 10 and conductivity capable of shielding radiated noise. In this manner, the heat sink 21 is entirely formed as a shielding layer capable of shielding radiated noise. However, the heat sink 21 need not be entirely formed as a shielding layer. The heat sink 21 may be formed to partly include a shielding layer. The shielding layer may be formed of a thin plate, mesh, or other publicly known shield structures made from a material that shields radiated noise. For example, the heat sink 21 may have a configuration in which a metal layer is laminated (e.g., plated), as a shielding layer, on an insulating layer having electrical insulating properties. That is, the heat sink 21 may have an insulating layer and a metal layer (i.e., a shielding layer) laminated on the insulating layer. The material capable of shielding radiated noise includes not only a material having conductivity but also a material having magnetism. Accordingly, the heat sink 21 may be formed from a material having magnetism instead of conductivity, or may be formed from a material including both conductivity and magnetism. Even with such configurations, the heat sink 21 is capable of shielding radiated noise.

The heat sink 21 includes a front surface 21a on which the power semiconductor element 10 is installed, a rear surface 21b opposite the front surface 21a, and a through hole 21c that passes from the front surface 21a to the rear surface 21b. The front surface 21a and the rear surface 21b may, for example, be flat surfaces parallel to each other. The power semiconductor element 10 being installed on the front surface 21a includes, in addition to a case in which the power semiconductor element 10 is directly fixed to the front surface 21a, a case in which the power semiconductor element 10 is indirectly fixed to the front surface 21a via other members. In the present embodiment, the power semiconductor element 10 is indirectly fixed to the front surface 21a via an insulating layer 31 and a conductive layer 32. Hereinafter, the direction from the front surface 21a toward the rear surface 21b is referred to as "down," and the direction from the rear surface 21b toward the front surface 21a is referred to as "up." Viewing the front surface 21a of the heat sink 21 from above is referred to as "plan view."

The insulating layer 31 is, for example, a flat ceramic layer having high thermal conductivity. The insulating layer 31 includes a rear surface 31b that faces the front surface 21a, and a front surface 31a that faces away from the front surface 21a. The conductive layer 32 is, for example, a flat copper plate and is disposed on the front surface 31a of the insulating layer 31. A conductive layer 33 and a conductive layer 34 are disposed on both sides of the conductive layer 32 on the front surface 31a. Each of the conductive layer 33 and the conductive layer 34 may, for example, be a flat copper plate. The conductive layer 33 and the conductive layer 34 are separated from the conductive layer 32 and electrically insulated from the conductive layer 32. The conductive layer 34 may be integrated with the conductive layer 32 without being separated from the conductive layer 32. In this case, it is possible to omit a wire 41a for connecting the conductive layer 32 and the conductive layer 34.

The through hole 21c and a through hole 31c are formed in the heat sink 21 and the insulating layer 31, respectively. The through hole 31c, for example, passes through the insulating layer 31 from the front surface 31a exposed between the conductive layer 32 and the conductive layer 33 to the rear surface 31b. The through hole 21c passes through the heat sink 21 from the front surface 21a to the rear surface 21b at a position communicating vertically with the through hole 31c. The through holes 21c and 31c have a size that allows a first control line part 43 and a second control line part 44 described further below to be inserted together therethrough. In the present embodiment, the through holes 21c and 31c have, for example, an inner diameter that is about 1.5 to 30 times the total cross-sectional area of the first control line part 43 and the second control line part 44. In this disclosure, since the through holes 21c and 31c form a single through hole communicating with each other, the through holes 21c and 31c may be collectively referred to as a "through hole H10."

The power semiconductor element 10 has a drain electrode 11 (first electrode), a source electrode 12 (second electrode), and a gate electrode 13 (control electrode) electrically insulated from each other. The source electrode 12 and the gate electrode 13 are positioned, for example, opposite the drain electrode 11 in the power semiconductor element 10. The positional relationship between the source electrode 12, the gate electrode 13, and the drain electrode 11 is not limited to such configuration, and may be changed as appropriate. In the present embodiment, the power semiconductor element 10 is disposed on the conductive layer 32 so that the drain electrode 11 faces the front surface 21a. The drain electrode 11 facing the front surface 21a includes, in addition to a case in which the drain electrode 11 directly faces the front surface 21a, a case in which the drain electrode 11 faces the front surface 21a via other members. In the present embodiment, the drain electrode 11 faces the front surface 21a via the conductive layer 32 and the insulating layer 31.

The gate electrode 13 and the source electrode 12 are positioned on a side of the drain electrode 11 opposite to the front surface 21a. Accordingly, in the present embodiment, the power semiconductor element 10 is disposed on the conductive layer 32 so that the gate electrode 13 and the source electrode 12 face upward. The gate electrode 13 and the source electrode 12 are electrically connected to the control board 3. The control signal E1 output from the control board 3 is input to the gate electrode 13 and the source electrode 12. The control signal E1 is a signal indicating a gate voltage (or a gate current) for controlling the switching of conduction and insulation between the drain electrode 11 and the source electrode 12. The gate voltage indicates the difference in potential between the source electrode 12 and the gate electrode 13, with the potential of the source electrode 12 as the reference.

The cover 22 is disposed on the front surface 21a of the heat sink 21 so as to cover the power semiconductor element 10. The cover 22 is used to protect the power semiconductor element 10, for example, from external moisture and dirt. The cover 22 is formed, for example, from a resin material having electrical insulating properties. The cover 22 has a top plate 22a and a side plate 22b. The top plate 22a is a plate member vertically facing the front surface 21a of the heat sink 21 via the power semiconductor element 10. The side plate 22b (side wall) is a frame-like plate member that vertically connects the top plate 22a and the front surface 21a and surrounds the power semiconductor element 10. The cover 22 is attached to the front surface 21a of the heat sink 21 so as to cover the power semiconductor element 10.

The power semiconductor module 5 is further provided with a first power line part 41 electrically connected to the drain electrode 11, a second power line part 42 electrically connected to the source electrode 12, the first control line part 43 electrically connected to the gate electrode 13, and the second control line part 44 electrically connected to the source electrode 12. In this specification, an element being "electrically connected" to another element means that two elements are connected in such a way that signal transmission and power supply are possible between the two elements. Consequently, "electrically connected" includes both a case in which two elements are directly connected to each other by a wire, and a case in which two elements are indirectly connected through other electric elements.

The first power line part 41 and the second power line part 42 form a main circuit for providing electric power from the drain electrode 11 to the source electrode 12. Each of the first power line part 41 and the second power line part 42 is formed of one or a plurality of electrical conductors capable of transmitting electric power from the drain electrode 11 to the source electrode 12. The electrical conductors forming the first power line part 41 and the second power line part 42 may be conductors such as wires, conductive wires, electrical wires, cables, or lead terminals. The first power line part 41 and the second power line part 42 extend upward from the drain electrode 11 and the source electrode 12 toward the top plate 22a, and extend from a region within a region R1 that is covered by the cover 22 to the outside of that region through the top plate 22a. That is, the first power line part 41 and the second power line part 42 extend from the inside to the outside of the casing 20 through the upper top plate 22a. More specifically, the first power line part 41 and the second power line part 42 extend above the top plate 22a through through holes H1 and H2 formed in the top plate 22a, respectively.

The first power line part 41 includes, for example, the wire 41a and a lead terminal 41b. The wire 41a connects the drain electrode 11 and the conductive layer 34. A base end of the lead terminal 41b is connected to the conductive layer 34. A distal end of the lead terminal 41b extends to the outside of the cover 22 through the through hole H1 in the top plate 22a. The lead terminal 41b is electrically connected to the drain electrode 11 via the conductive layer 34 and the wire 41a. Accordingly, the electric power applied to the lead terminal 41b is input to the drain electrode 11 through the conductive layer 34 and the wire 41a.

The second power line part 42 includes, for example, a wire 42a and a lead terminal 42b. The wire 42a connects the source electrode 12 and the conductive layer 33. A base end of the lead terminal 42b is connected to the conductive layer 33. A distal end of the lead terminal 42b extends to the outside of the cover 22 through the through hole H2 in the top plate 22a. The lead terminal 42b is electrically connected to the source electrode 12 through the conductive layer 33 and the wire 42a. Accordingly, the electric power output from the source electrode 12 is transmitted to the lead terminal 42b through the wire 42a and the conductive layer 33.

The first control line part 43 and the second control line part 44 form a control circuit for applying the control signal E1 to the gate electrode 13. Each of the first control line part 43 and the second control line part 44 is formed of one or a plurality of electrical conductors capable of transmitting the gate voltage indicated by the control signal E1 to the gate electrode 13. The electrical conductors forming the first control line part 43 and the second control line part 44 may be conductors such as wires, conductive wires, electrical wires, cables, or lead terminals. The first control line part 43 and the second control line part 44 extend to the outside of the casing 20 from the inside of the casing 20 through the through hole H10 in the lower heat sink 21.

In the present embodiment, the first power line part 41 and the second power line part 42 extend to the outside of the casing 20 through the upper cover 22. In contrast, the first control line part 43 and the second control line part 44 extend to the outside of the casing 20 through the lower heat sink 21. In other words, only the first control line part 43 and the second control line part 44 among the first power line part 41, the second power line part 42, the first control line part 43, and the second control line part 44 extend to a region R2 on the rear surface 21b of the heat sink 21 through the through hole H10. As a result, the region R1 to which the first power line part 41 and the second power line part 42 extend and the region R2 to which the first control line part 43 and the second control line part 44 extend are separated by the heat sink 21. The region R1 may be the region facing the front surface 21a among the pair of regions positioned on either side of the heat sink 21. The region R2 may be the region facing the rear surface 21b among the pair of regions.

Thus, the first control line part 43 and the second control line part 44 extend to a side of the heat sink 21 opposite to the first power line part 41 and the second power line part 42. As a result, the portions of the first control line part 43 and the second control line part 44, including at least distal ends thereof, are disposed in the region R2 on the rear surface 21b, and the portions of the first power line part 41 and the second power line part 42, including at least distal ends thereof, are disposed in the region R1. The distal end of the first power line part 41 refers to the end opposite to the base end of the first power line part 41 connected to the drain electrode 11. The distal end of the second power line part 42 refers to the end opposite to the base end of the second power line part 42 connected to the source electrode 12. The distal end of the first control line part 43 refers to the end opposite to the base end of the first control line part 43 connected to the gate electrode 13. The distal end of the second control line part 44 refers to the end opposite to the base end of the second control line part 44 connected to the source electrode 12.

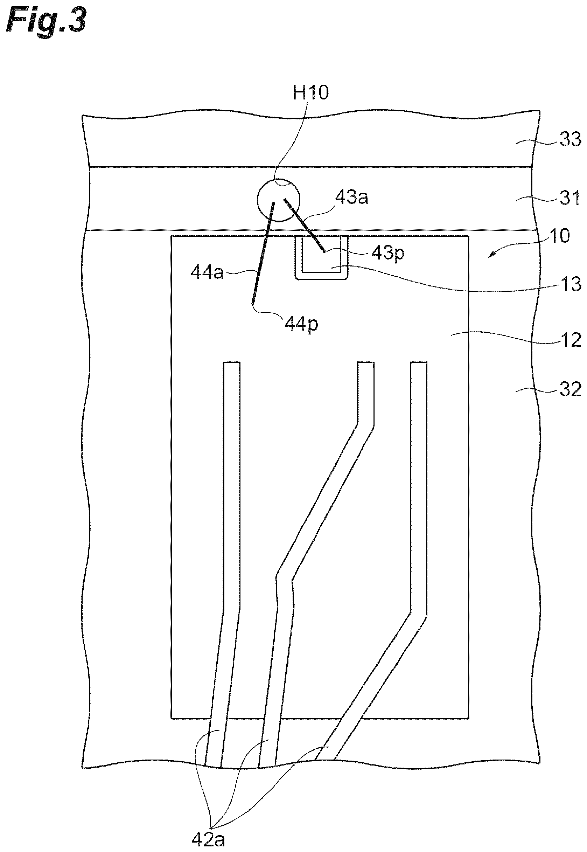

The through hole H10 through which the first control line part 43 and the second control line part 44 pass is formed at a position that does not overlap the gate electrode 13 and the source electrode 12, more specifically, a position separated from the gate electrode 13 and the source electrode 12, in plan view as illustrated in FIGS. 2 and 3. For example, as illustrated in FIG. 3, the through hole H10 is formed at a position separated from the gate electrode 13 and the source electrode 12, and a position at which the total length of a line connecting a connection point 43p of the first control line part 43 to the gate electrode 13 and the center of the through hole H10 and a line connecting a connection point 44p of the second control line part 44 to the source electrode 12 and the center of the through hole H10 is the shortest. However, the through hole H10 need not necessarily be formed at the position where the aforementioned total length is the shortest (i.e., the ideal position). For example, if the through hole H10 cannot be formed at such ideal position due to design or manufacturing constraints, the through hole H10 may be formed at a position offset from the ideal position.

As illustrated in FIG. 2, the first control line part 43 includes, for example, a wire 43a and a connection terminal 43b. The wire 43a is connected to the gate electrode 13. The wire 43a extends downward from the gate electrode 13 and extends to the region R2 on the rear surface 21b of the heat sink 21 through the through hole H10. That is, the wire 43a extends to the outside of the casing 20 from the inside of the casing 20 through the heat sink 21. The wire 43a that extends below the heat sink 21 is connected to the control board 3 through the connection terminal 43b.

The second control line part 44 includes, for example, a wire 44a and a connection terminal 44b. The wire 44a is connected to the source electrode 12 at a position different from the connection point of the wire 42a to the source electrode 12 (see FIG. 3). The wire 44a extends downward from the source electrode 12 and extends to the region R2 on the rear surface 21b of the heat sink 21 through the through hole H10 together with the wire 43a of the first control line part 43. That is, the wire 44a extends to the outside of the casing 20 from the inside of the casing 20 through the heat sink 21 together with the wire 43a. The wire 44a that extends below the heat sink 21 is connected to the control board 3 through the connection terminal 44b. A reference potential of the control signal E1 is applied to the second control line part 44. The reference potential refers to an arbitrarily determined reference potential and is not limited to zero volts. The gate voltage indicated by the control signal E1 is represented as the difference between the potential of the first control line part 43 and the reference potential of the second control line part 44.

When the control signal E1 is input to the gate electrode 13 by the first control line part 43 and the second control line part 44, the timing of turning the power semiconductor element 10 on or off is controlled. When the gate voltage indicated by the control signal E1 is greater than or equal to a threshold voltage (e.g., 5V), the power semiconductor element 10 turns on, and a conduction state is established between the drain electrode 11 and the source electrode 12. When this happens, high power, such as several thousand amperes or several thousand volts, is applied to the drain electrode 11 and the source electrode 12 through the first power line part 41 and the second power line part 42. In contrast, when the gate voltage is less than the threshold voltage, the power semiconductor element 10 turns off, and an insulated state is established between the drain electrode 11 and the source electrode 12. Thus, by switching the conduction and insulation between the drain electrode 11 and the source electrode 12 according to the control signal E1, the electric power conversion apparatus 1 switches the mode of electric power.

The effects achieved by the power semiconductor module 5 and the electric power conversion apparatus 1 of the present embodiment will be described below together with the problem of a comparative example.

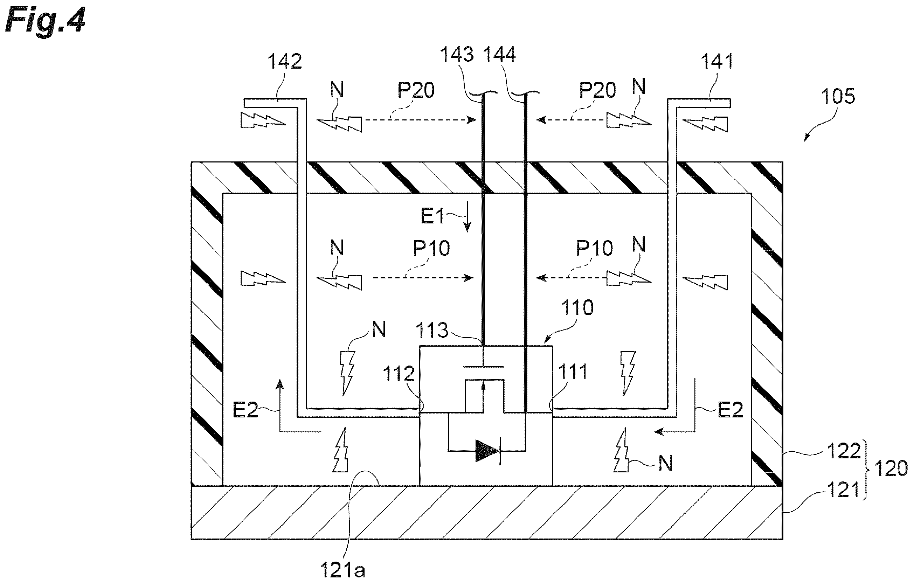

FIG. 4 is a simplified cross-sectional view illustrating a power semiconductor module 105 of a comparative example. In FIG. 4, a power semiconductor element 110 is schematically shown as a circuit diagram. The power semiconductor module 105 is provided with a casing 120 having a heat sink 121 and a cover 122, the power semiconductor element 110 disposed on a front surface 121a of the heat sink 121, a first power line part 141 connected to a drain electrode 111, a second power line part 142 connected to a source electrode 112, a first control line part 143 connected to a gate electrode 113, and a second control line part 144 connected to the source electrode 112. In the power semiconductor module 105, the control signal E1 is input to the gate electrode 113 through the first control line part 143 and the second control line part 144. Conduction and insulation between the drain electrode 111 and the source electrode 112 are alternately switched according to the control signal E1. The first power line part 141, the second power line part 142, the first control line part 143, and the second control line part 144 extend to the outside of the casing 120 together through the upper cover 122.

A reference potential of the control signal E1 is applied to the second control line part 144. The second power line part 142 and the second control line part 144 are both connected to the source electrode 112. Unlike the second power line part 142, to which high electric power E2 is applied, a small potential such as zero volts or a few volts is applied to the second control line part 144. The potential of the second power line part 142 to which the high electric power E2 is applied tends to vary greatly in response to variations in the electric current flowing through the second power line part 142. In contrast, since no electric current flows through the second control line part 144, the potential of the second control line part 144 is stable. Thus, in a case in which the gate voltage is set with the potential of the second power line part 142 as the reference, without providing the second control line part 144, it is expected that the control signal E1 would be disturbed in response to the variations in the potential of the second power line part 142. In contrast, in the case in which the second control line part 144 is provided, using a stable potential as the reference can suppress disturbances in the control signal E1.

However, in the case in which the first power line part 141, the second power line part 142, the first control line part 143, and the second control line part 144 all extend in the same direction such as in the power semiconductor module 105, large radiated noise N emitted from the first power line part 141 and the second power line part 142 to which the high electric power E2 is applied may easily propagate to the first control line part 143 and the second control line part 144. The radiated noise N, being electromagnetic waves, has the property of traveling in a straight line. Consequently, the radiated noise N emitted from the first power line part 141 and the second power line part 142 easily propagates to the first control line part 143 and the second control line part 144 that extend upward together with the first power line part 141 and the second power line part 142.

For example, the radiated noise N emitted from the first power line part 141 and the second power line part 142 inside the casing 120 propagates to the first control line part 143 and the second control line part 144 through a first path P10. The radiated noise N emitted from the first power line part 141 and the second power line part 142 outside the casing 120 propagates to the first control line part 143 and the second control line part 144 through a second path P20. The radiated noise N generated inside and outside the casing 120 thus easily propagates to the first control line part 143 and the second control line part 144. The radiated noise N propagated to the first control line part 143 and the second control line part 144 becomes a factor that causes variations in the control signal E 1 input to the gate electrode 113.

The radiated noise N emitted from the first power line part 141 and the second power line part 142 increases according to the electric power E2 applied to the first power line part 141 and the second power line part 142. Furthermore, the radiated noise N is greater the closer it is to the source of the radiated noise N. The radiated noise N thus tends to be particularly large in the power semiconductor module 105 which is the source of the radiated noise N and in its vicinity. The high electric power E2, such as several thousand volts or several thousand amperes, is applied to the first power line part 141 and the second power line part 142. Consequently, large radiated noise N tends to be emitted from the first power line part 141 and the second power line part 142. In contrast, small electric power, such as at most several tens of volts or several tens of amperes, is applied to the first control line part 143 and the second control line part 144 to which the control signal E1 is input. Consequently, if the large radiated noise N from the first power line part 141 and the second power line part 142 propagates to the first control line part 143 and the second control line part 144, the potential of the first control line part 143 and the second control line part 144 will vary greatly due to the influence of the radiated noise N, thereby causing the control signal E1 input to the gate electrode 113 to be greatly disturbed.

For example, when the threshold voltage of the power semiconductor element 110 is 5V, it is necessary to apply a gate voltage of 5V or more to the gate electrode 113 to control the power semiconductor element 110 to an on state. For example, when a 5V potential is applied to the first control line part 143 and a zero V potential is applied to the second control line part 144, 5V which is the potential difference between the first control line part 143 and the second control line part 144 is input to the gate electrode 113, and the state between the drain electrode 111 and the source electrode 112 is controlled to a conduction state. However, if the potential of one or both of the first control line part 143 and the second control line part 144 vary greatly due to the influence of the radiated noise N, the voltage input to the gate electrode 113 will vary greatly.

For example, if the potential of the second control line part 144 to which a zero volt potential has been applied varies to 2V due to the influence of the radiated noise N, with 5V being applied to the first control line part 143, the potential difference between the first control line part 143 and the second control line part 144 becomes 3V, which is below the threshold voltage of 5V. In this case, the state between the drain electrode 111 and the source electrode 112 is controlled to the insulated state, resulting in a malfunction in which the power semiconductor element 110 is unintentionally controlled to an off state. Similarly, if the potential of the first control line part 143 to which 5V has been applied varies and decreases, a malfunction will occur in the power semiconductor element 110. Conversely, even if a potential for turning off the power semiconductor element 110 is applied to the first control line part 143 and the second control line part 144, a malfunction may occur in which the power semiconductor element 110 is unintentionally controlled to the on state due to the influence of the radiated noise N. Furthermore, depending on the magnitude of the radiated noise N, there is a risk that a voltage greater than the withstand voltage of the power semiconductor element 110 may be input to the gate voltage.

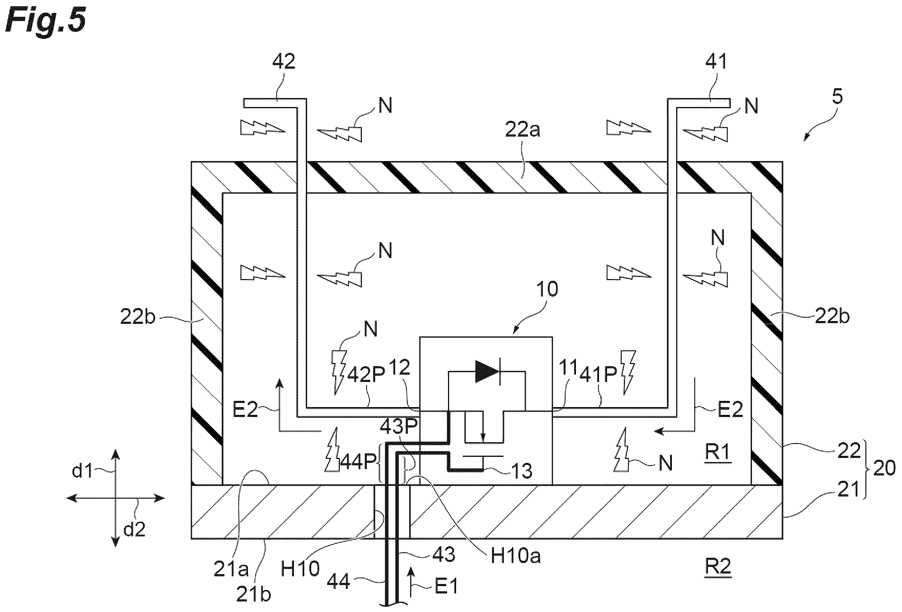

In contrast, in the power semiconductor module 5 according to the present embodiment, the first control line part 43 and the second control line part 44 extend downward opposite the first power line part 41 and the second power line part 42 as illustrated in FIG. 5. FIG. 5 is a simplified cross-sectional view illustrating the power semiconductor module 5 according to the present embodiment, schematically showing the power semiconductor element 10 as a circuit diagram. As illustrated in FIG. 5, the first control line part 43 and the second control line part 44 extend to the region R2 on the side of the heat sink 21, which is a shielding plate shielding the radiated noise N, opposite to the region R1 to where the first power line part 41 and the second power line part 42 extend. The large radiated noise N emitted from a first power wiring part and a second wiring part is thus shielded by the heat sink 21, and does not propagate to the first control line part 43 and the second control line part 44.

The radiated noise N emitted from the first power line part 41 and the second power line part 42 inside the casing 20 is shielded by the heat sink 21 and does not propagate to the first control line part 43 and the second control line part 44 on the rear surface 21b of the heat sink 21. The first control line part 43 and the second control line part 44 are not disposed in the direction in which the radiated noise N emitted from the first power line part 41 and the second power line part 42 propagates outside the casing 20, so that such radiated noise N also does not propagate to the first control line part 43 and the second control line part 44. Thus, by extending the first control line part 43 and the second control line part 44 to the opposite side from the first power line part 41 and the second power line part 42 through the heat sink 21 and the heat sink 21 being utilized as a shielding plate, it is possible to suppress the propagation of the large radiated noise N from the first power line part 41 and the second power line part 42 to the first control line part 43 and the second control line part 44. This can suppress large variations in the control signal E1, which is based on the potentials of the first control line part 43 and the second control line part 44, due to the influence of the radiated noise N. As a result, the occurrence of operational failures such as the malfunctions in the power semiconductor element 10 caused by variations in the control signal E1 can be suppressed.

As illustrated in FIG. 5, the first control line part 43 includes, in a path of the first control line part 43 between an opening H10a of the through hole H10 on the front surface 21a and the gate electrode 13, a first extension part 43P that extends along an extension direction d1 of the through hole H10 from the opening H10a. Similarly, the second control line part 44 includes, in a path of the second control line part 44 between the opening H10a and the source electrode 12, a second extension part 44P that extends along the extension direction d1 from the opening H10a alongside the first control line part 43. The extension direction d1 may be a direction intersecting (orthogonal to, in one example) the front surface 21a. The first power line part 41 includes a portion 41P that extends from the drain electrode 11 along a direction d2 intersecting the extension direction d1 inside the casing 20. Similarly, the second power line part 42 includes a portion 42P that extends from the source electrode 12 along the direction d2 inside the casing 20.

The portion 42P of the second power line part 42 is a facing portion that faces the first extension part 43P and the second extension part 44P in the direction d2. The first extension part 43P and the second extension part 44P extend from the portion 42P of the second power line part 42 so as to approach the opening H10a in the direction d2. In other words, the first extension part 43P and the second extension part 44P extend in the direction d2 so that the distance from the portion 42P of the second power line part 42 in the direction d2 increases monotonically. It can thus be said that the first extension part 43P and the second extension part 44P are monotonically increasing regions in which the distance from the portion 42P of the second power line part 42 in the direction d2 increases monotonically. The portion 41P of the first power line part 41 may be the facing portion that faces the first extension part 43P and the second extension part 44P in the direction d2.

As in the present embodiment, the first power line part 41 and the second power line part 42 may extend to the outside of the casing 20 through the top plate 22a. In this case, the first control line part 43 and the second control line part 44 extend to the opposite side from the first power line part 41 and the second power line part 42, so that the propagation of the radiated noise N from the first power line part 41 and the second power line part 42 to the first control line part 43 and the second control line part 44 can be more effectively suppressed.

As in the present embodiment, the drain electrode 11 may be disposed so as to face the front surface 21a, the source electrode 12 and the gate electrode 13 may be disposed on the side of the drain electrode 11 opposite to the front surface 21a, and the through hole H10 may be formed in a position that does not overlap the source electrode 12 and the gate electrode 13 in plan view. In this case, the configuration in which the first control line part 43 and the second control line part 44 extend to the region R2 on the rear surface 21b of the heat sink 21 through the through hole H10 can be easily achieved.

As in the present embodiment, the first control line part 43 and the second control line part 44 may extend to the region R2 on the rear surface 21b through the through hole H10. In the case in which the first control line part 43 and the second control line part 44 are passed through the through hole H10 together, the distance between the first control line part 43 and the second control line part 44 becomes shorter, and accordingly, the area of a loop formed by the first control line part 43 and the second control line part 44 becomes smaller. If the area of the loop is reduced in this manner, the electromotive force that is generated when electromagnetic waves (radiated noise N) intersect the loop can be reduced. This can reduce the risk of large conductive noise being generated in the first control line part 43 and the second control line part 44.

Although an embodiment of the present disclosure has been described above, the present disclosure is not limited to the above embodiment.

### <Variation 1>

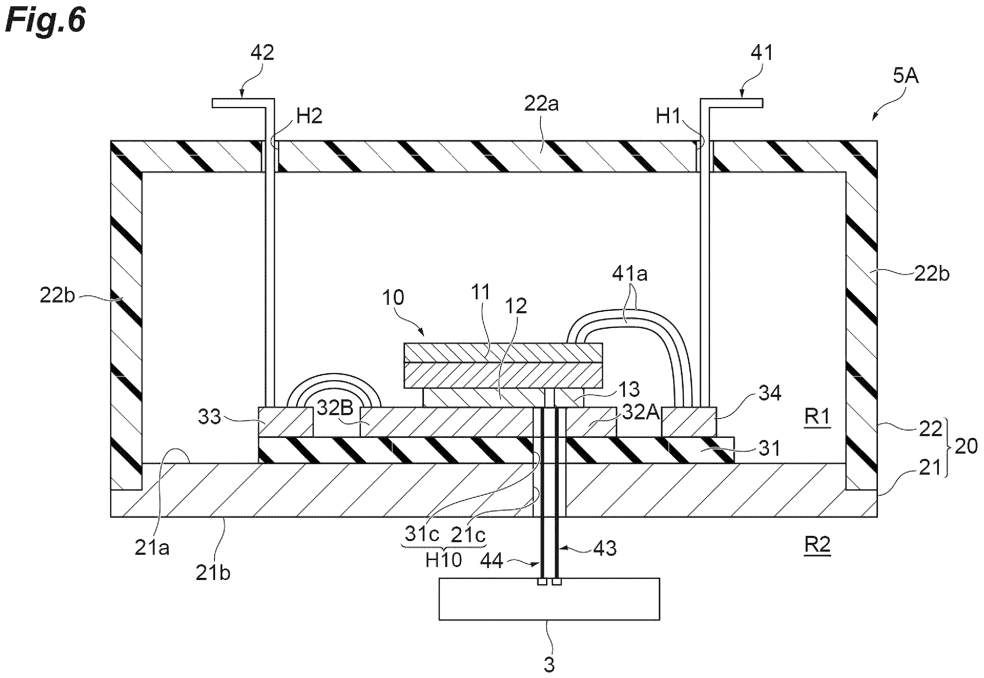

FIG. 6 is a cross-sectional view illustrating a power semiconductor module 5A of Variation 1. In the embodiment described above, the power semiconductor element 10 is installed on the front surface 21a of the heat sink 21 so that the gate electrode 13 faces upward. However, in Variation 1, the power semiconductor element 10 is disposed on the front surface 21a of the heat sink 21 so that the gate electrode 13 faces downward. Thus, in the power semiconductor module 5A, the power semiconductor element 10 is disposed on the heat sink 21 in an upside-down state. As a result, the source electrode 12 and the gate electrode 13 are disposed so as to face the front surface 21a. The drain electrode 11 is disposed on a side of the source electrode 12 and the gate electrode 13 opposite to the front surface 21a.

In this configuration, the through hole H10 formed in the insulating layer 31 and the heat sink 21 is disposed at a position overlapping the gate electrode 13 and the source electrode 12 in plan view. The gate electrode 13 and the source electrode 12 are connected, respectively, to conductive layers 32A and 32B which are electrically insulated from each other. Similarly to the embodiment described above, the conductive layer 34 may be integrated with the conductive layer 32A without being separated from the conductive layer 32A. In this case, it is possible to omit the wire 41a for connecting the conductive layer 34 and the conductive layer 32A. The first control line part 43 and the second control line part 44 connected to the gate electrode 13 and the source electrode 12, respectively, extend to the region R2 on the rear surface 21b of the heat sink 21 through the lower through hole H10. In the configuration in which the first control line part 43 and the second control line part 44 extend directly from the lower through hole H10 in this manner, the distance from the gate electrode 13 and the source electrode 12 to the through hole H10 can be kept as short as possible, so that the portions of the first control line part 43 and the second control line part 44 exposed inside the casing 20 where the radiated noise N may propagate can be kept as small as possible. This can reduce the risk of the radiated noise N propagating to the first control line part 43 and the second control line part 44 inside the casing 20.

### <Variation 2>

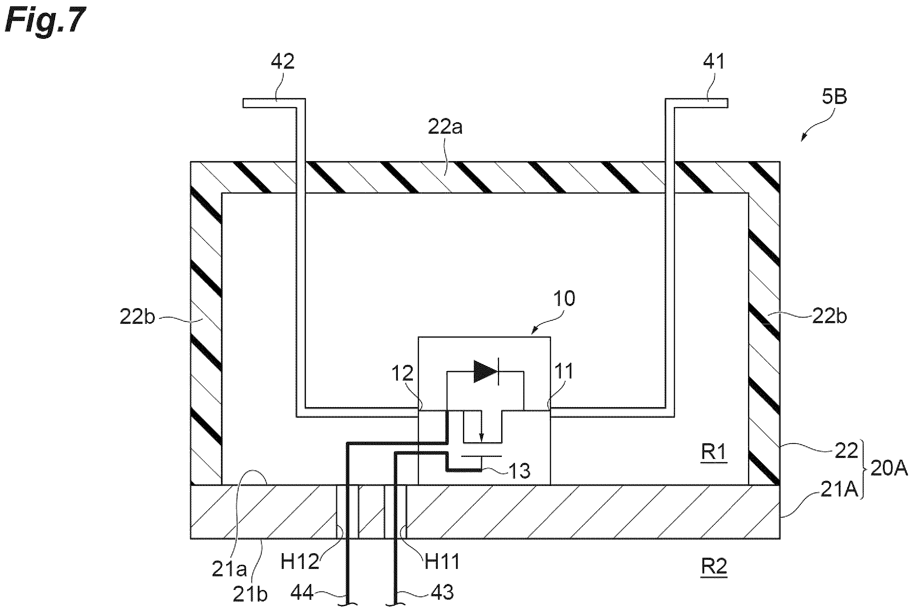

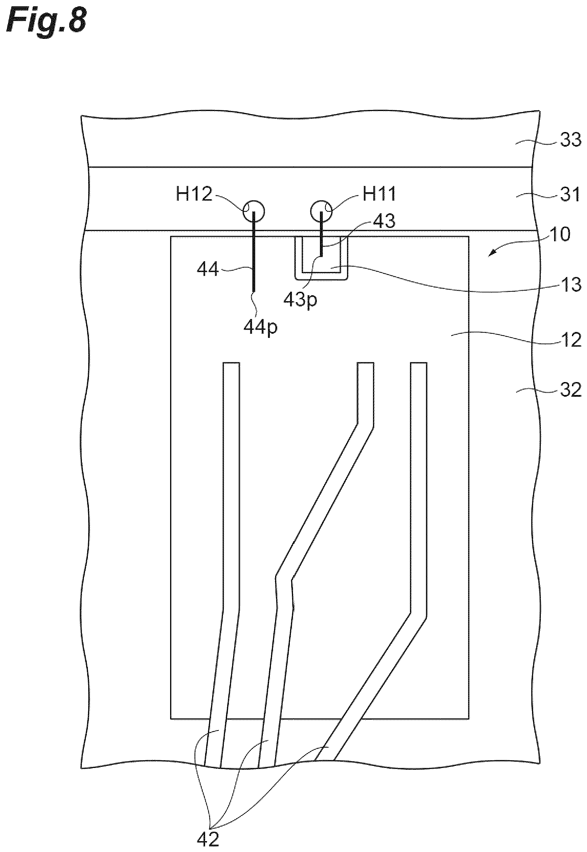

FIG. 7 is a simplified cross-sectional view illustrating a power semiconductor module 5B of Variation 2. FIG. 8 is a plan view of the power semiconductor element 10 of the power semiconductor module 5B viewed from above. In the embodiment described above, one through hole H10 is formed in the heat sink 21. However, in Variation 2, a first through hole H11 and a second through hole H12 are formed in a heat sink 21A. As illustrated in FIGS. 7 and 8, the first through hole H11 and the second through hole H12 are formed at different positions of the heat sink 21A in plan view. The first control line part 43 extends to the region R2 on the rear surface 21b through the first through hole H11. The second control line part 44 extends to the region R2 on the rear surface 21b through the second through hole H12.

As illustrated in FIG. 8, the first through hole H11 is formed at a position closer to the connection point 43p of the first control line part 43 to the gate electrode 13 than the connection point 44p of the second control line part 44 to the source electrode 12 in plan view. For example, the first through hole H11 is formed at a position adjacent to the gate electrode 13 at the shortest distance in plan view. The first control line part 43 reaches the first through hole H11 from the connection point 43p of the first control line part 43 to the gate electrode 13 by the shortest distance. The second through hole H12 is formed at a position closer to the connection point 44p of the second control line part 44 to the source electrode 12 than the connection point 43p of the first control line part 43 to the gate electrode 13 in plan view. The second through hole H12 is formed at a position adjacent to the source electrode 12 at the shortest distance in plan view. The second control line part 44 reaches the second through hole H12 from the connection point 44p of the second control line part 44 to the source electrode 12 by the shortest distance.

In this manner, in the power semiconductor module 5B, the first control line part 43 and the second control line part 44 can reach the first through hole H11 and the second through hole H12, respectively, by the shortest distance. Thus, the portions of the first control line part 43 and the second control line part 44 exposed inside a casing 20A where the radiated noise N may propagate can be kept as small as possible, so that the risk of the radiated noise N propagating to the first control line part 43 and the second control line part 44 inside the casing 20A can be reduced.

### <Variation 3>

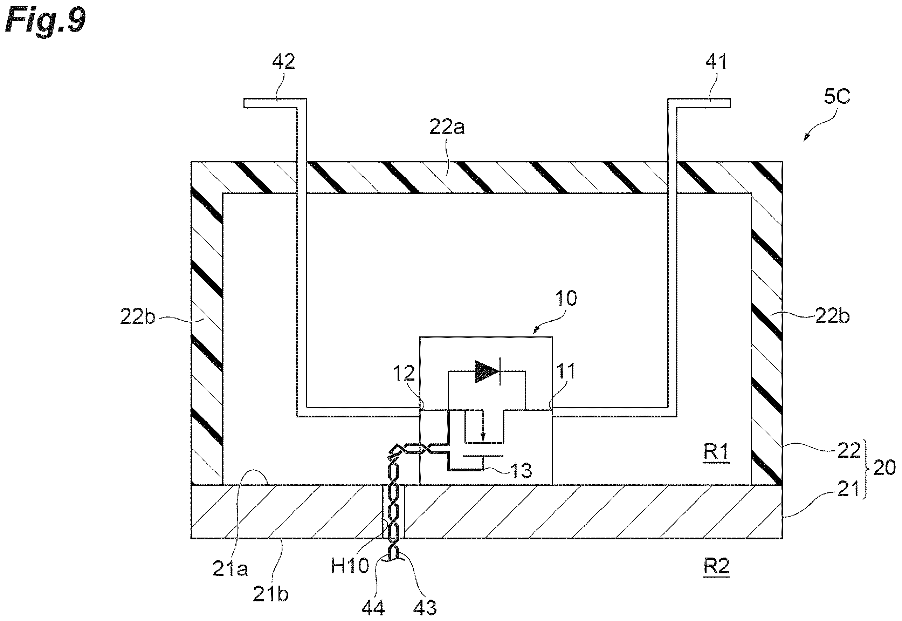

FIG. 9 is a simplified cross-sectional view illustrating a power semiconductor module 5C of Variation 3. As illustrated in FIG. 9, in the power semiconductor module 5C, the first control line part 43 and the second control line part 44 which are respectively connected to the gate electrode 13 and the source electrode 12 of the power semiconductor element 10 are twisted together. The first control line part 43 and the second control line part 44 are twisted together and extend below the heat sink 21 from the inside of the casing 20 through the through hole H10.

In the case in which the first control line part 43 and the second control line part 44 are twisted in this manner, even if the radiated noise N from the first power line part 41 and the second power line part 42 propagates to the first control line part 43 and the second control line part 44, the conductive noise generated in the first control line part 43 and the second control line part 44 and the conductive noise generated in the twisted portion therebeyond will act to cancel each other out. This can reduce the risk of large conductive noise being generated in the first control line part 43 and the second control line part 44.

### <Variation 4>

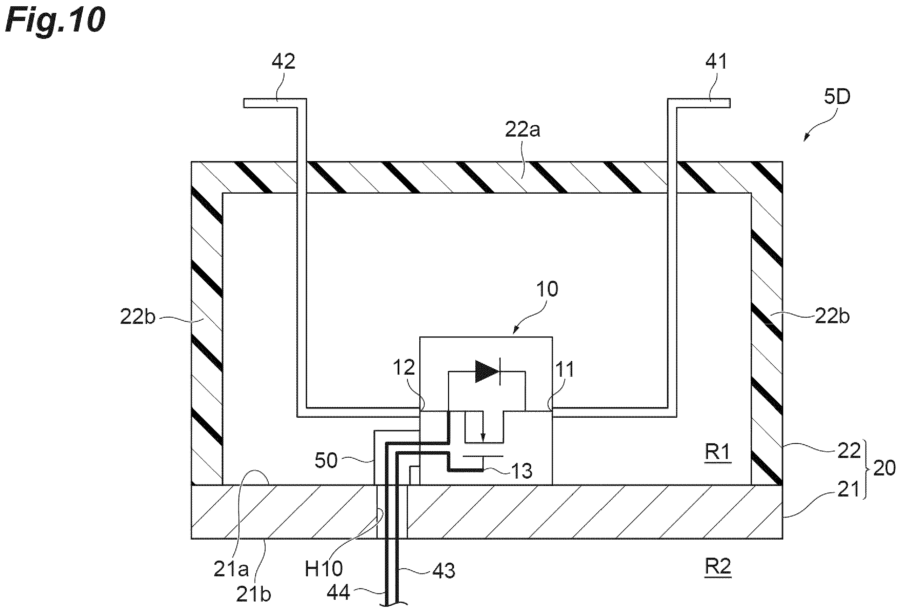

FIG. 10 is a simplified cross-sectional view illustrating a power semiconductor module 5D of Variation 4. As illustrated in FIG. 10, the power semiconductor module 5D is provided with an electromagnetic shield 50 that surrounds the first control line part 43 and the second control line part 44 inside the casing 20. The electromagnetic shield 50 is a tubular member extending between the gate electrode 13 and source electrode 12 and an opening of the through hole H10 on the front surface 21a. The electromagnetic shield 50 is disposed so as to surround the first control line part 43 and the second control line part 44 inside the casing 20. The first control line part 43 and the second control line part 44 extend below the heat sink 21 from the through hole H10 through the inside of the electromagnetic shield 50.

The electromagnetic shield 50 is formed including a shielding layer capable of shielding the radiated noise N from the first power line part 41 and the second power line part 42. The electromagnetic shield 50 may be formed so as to be entirely formed as a shielding layer, or may be formed to partly include a shielding layer. The shielding layer capable of shielding the radiated noise N includes not only a material having conductivity but also a material having magnetism. Accordingly, the shielding layer that forms the electromagnetic shield 50 may be formed from a material having magnetism instead of conductivity, or may be formed from a material including both conductivity and magnetism. The electromagnetic shield 50 may, for example, be a conductive tube formed, for example, of an aluminum or copper pipe. The electromagnetic shield 50 may be formed from a conductive thin film such as an aluminum foil or a copper foil, or may be a conductive tubular mesh woven from aluminum wire or copper wire. In such configuration, the radiated noise N from the first power line part 41 and the second power line part 42 is shielded by the electromagnetic shield 50, so that the propagation of the radiated noise N to the first control line part 43 and the second control line part 44 inside the electromagnetic shield 50 can be suppressed.

### <Variation 5>

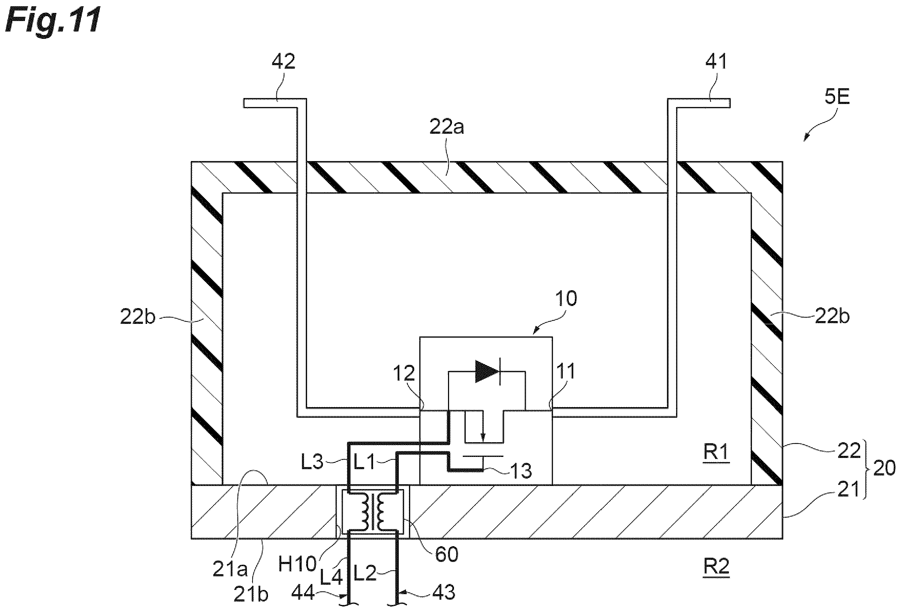

FIG. 11 is a cross-sectional view illustrating a power semiconductor module 5E of Variation 5. As illustrated in FIG. 11, in the power semiconductor module 5E, the first control line part 43 and the second control line part 44 include a common mode filter 60 capable of removing a common mode component of the conductive noise conducted through the first control line part 43 and the second control line part 44. The conductive noise is the electromagnetic noise that travels through conductors used for power input and output, and is generated by the switching operation of the power semiconductor element 10.

The common mode filter 60 is disposed, for example, inside the through hole H10 in the heat sink 21. That is, the common mode filter 60 is disposed between the front surface 21a and the rear surface 21b and is embedded inside the heat sink 21. The first control line part 43 includes a line L 1 that connects the gate electrode 13 and the common mode filter 60 inside the casing 20, the common mode filter 60 inside the heat sink 21, and a line L2 that connects the common mode filter 60 and the connection terminal 43b (see FIG. 2) outside the casing 20. The second control line part 44 includes a line L3 that connects the source electrode 12 and the common mode filter 60 inside the casing 20, the common mode filter 60 inside the heat sink 21, and a line L4 that connects the common mode filter 60 and the connection terminal 44b (see FIG. 2) outside the casing 20.

In the power semiconductor module 5E, the common mode component of the conductive noise that may be generated in the first control line part 43 and the second control line part 44 can be removed, so that variations in the control signal E1 caused by the common mode component can be suppressed. Furthermore, the propagation of the radiated noise N from the first power line part 41 and the second power line part 42 to the first control line part 43 and the second control line part 44 through the common mode filter 60 can be suppressed by the common mode filter 60 being disposed inside the through hole H10.

The common mode filter 60 need not be disposed inside the through hole H10. For example, the common mode filter 60 may be disposed on the front surface 21a or the rear surface 21b. In the case in which the common mode filter 60 is disposed on the front surface 21a, the first control line part 43 and the second control line part 44 between the gate electrode 13 and source electrode 12 and the common mode filter 60 may be twisted together. In the case in which the common mode filter 60 is disposed on the front surface 21a, the first control line part 43 and the second control line part 44 between the gate electrode 13 and source electrode 12 and the common mode filter 60, and the common mode filter 60 on the front surface 21a may be surrounded by an electromagnetic shield. The power semiconductor module 5E may be provided with a ferrite core instead of the common mode filter 60. In this case, the first control line part 43 and the second control line part 44 may linearly pass through an annular ferrite core. Alternatively, the first control line part 43 and the second control line part 44 may be wound around an annular ferrite core to form a common mode choke coil.

### <Variation 6>

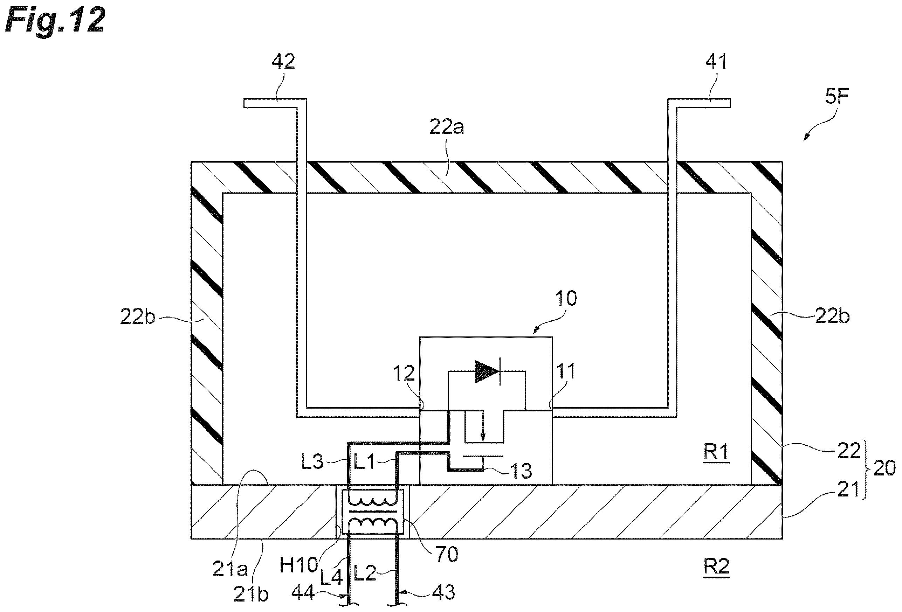

FIG. 12 is a cross-sectional view illustrating a power semiconductor module 5F of Variation 6. As illustrated in FIG. 12, in the power semiconductor module 5F, the first control line part 43 and the second control line part 44 include a transformer 70 capable of removing the common mode component of the conductive noise conducted through the first control line part 43 and the second control line part 44. The transformer 70 is disposed, for example, inside the through hole H10 in the heat sink 21. That is, the transformer 70 is disposed between the front surface 21a and the rear surface 21b and is embedded inside the heat sink 21. The first control line part 43 includes the line L1 that connects the gate electrode 13 and the transformer 70 inside the casing 20, the transformer 70 inside the heat sink 21, and the line L2 that connects the transformer 70 and the connection terminal 43b (see FIG. 2) outside the casing 20. The second control line part 44 includes the line L3 that connects the source electrode 12 and the transformer 70 inside the casing 20, the transformer 70 inside the heat sink 21, and the line L4 that connects the transformer 70 and the connection terminal 44b (see FIG. 2) outside the casing 20.

In the power semiconductor module 5F, the common mode component of the conductive noise that may be generated in the first control line part 43 and the second control line part 44 can be removed, so that variations in the control signal E1 caused by the common mode component can be suppressed. Additionally, the propagation of the radiated noise N to the first control line part 43 and the second control line part 44 through the transformer 70 can be suppressed by the transformer 70 being disposed inside the through hole H10. Furthermore, disposing the transformer 70 inside the heat sink 21 enables the transformer 70 to demonstrate the function of electrically insulating the inside and outside of the casing 20.

The transformer 70 need not be disposed inside the through hole H10. For example, the transformer 70 may be disposed on the front surface 21a or the rear surface 21b. In the case in which the transformer 70 is disposed on the front surface 21a, the first control line part 43 and the second control line part 44 between the gate electrode 13 and source electrode 12 and the transformer 70 may be twisted together. In the case in which the transformer 70 is disposed on the front surface 21a, the first control line part 43 and the second control line part 44 between the gate electrode 13 and source electrode 12 and the transformer 70, and the transformer 70 on the front surface 21a may be surrounded by an electromagnetic shield.

The present disclosure is not limited to the examples described above, and many other variations are possible. In the embodiment and variations described above, the case in which the first power line part and the second power line part extend to the outside of the casing from the upper top plate has been exemplified. However, the first power line part and the second power line part may extend to the outside of the casing from a lateral side plate. In the embodiment and variations described above, the case in which the heat sink on which the semiconductor element is disposed has a flat shape has been exemplified. However, the shape of the heat sink is not limited to a flat shape and may have other shapes (e.g., U-shape). The heat sink may have a cooling hole for passing a coolant, in addition to the through hole. In this case, the cooling hole may be formed from an insulating material such as resin. The heat sink may be formed having heat dissipation fins that exchange heat with the coolant. In this case, the dissipation fins may be formed from a material having high thermal conductivity and low conductivity (e.g., graphite). The cover may be formed from a conductive material such as a metal material, and is not limited to a resin material.

The gist of the present disclosure is shown below.
[1] A power semiconductor module including:
   a power semiconductor element including a first electrode, a second electrode, and a control electrode, and configured to alternately switch conduction and non-conduction between the first electrode and the second electrode according to a control signal applied to the control electrode;
   a heat sink including a front surface on which the power semiconductor element is installed and a rear surface opposite the front surface, and capable of dissipating heat from the power semiconductor element;
   a first power line part and a second power line part electrically connected to the first electrode and the second electrode, respectively, and configured to transmit electric power between the first electrode and the second electrode;
   a first control line part electrically connected to the control electrode and configured to apply the control signal to the control electrode; and
   a second control line part electrically connected to the second electrode and configured to provide a reference potential of the control signal,
   wherein the heat sink includes a shielding layer formed from a material having at least one of electrical conductivity and magnetism,
   wherein the heat sink includes at least one through hole passing from the front surface to the rear surface, and
   wherein only the first control line part and the second control line part among the first power line part, the second power line part, the first control line part, and the second control line part extend to a region on the rear surface of the heat sink through the through hole.
[2] The power semiconductor module according to [1],
   wherein the first control line part includes a first monotonically increasing region extending from a cross-section of the through hole, a distance between the first monotonically increasing region and the first power line part and second power line part increasing monotonically in a direction from the control electrode toward the through hole, and
   wherein the second control line part includes a second monotonically increasing region extending from a cross-section of the through hole, a distance between the second monotonically increasing region and the first power line part and second power line part increasing monotonically in a direction from the second electrode toward the through hole.
[3] The power semiconductor module according to [1] or [2], including a cover covering the front surface of the heat sink on which the power semiconductor element is placed,
   wherein the first power line part and the second power line part extend toward the cover from the first electrode and the second electrode, and extend to an outside of a region covered by the cover through the cover.
[4] The power semiconductor module according to [3],
   wherein the cover includes a side wall and a top plate facing the front surface with the side wall interposed therebetween, and
   wherein the first power line part and the second power line part extend toward the top plate from the first electrode and the second electrode, and extend to the outside of the region covered by the cover through the top plate.
[5] The power semiconductor module according to any one of [1] to [4],
   wherein the first electrode is disposed to face the front surface,
   wherein the second electrode and the control electrode are disposed on a side of the first electrode opposite to the front surface, and
   wherein the at least one through hole is formed at a position not overlapping the second electrode and the control electrode in plan view of the heat sink.
[6] The power semiconductor module according to any one of [1] to [4],
   wherein the second electrode and the control electrode are disposed to face the front surface,
   wherein the first electrode is disposed on a side of the second electrode and the control electrode opposite to the front surface, and
   wherein the at least one through hole is formed at a position overlapping the second electrode and the control electrode in plan view of the heat sink.
[7] The power semiconductor module according to any one of [1] to [6],
   wherein the heat sink includes one through hole, and
   wherein the first control line part and the second control line part extend to the region on the rear surface through the one through hole.
[8] The power semiconductor module according to [7], wherein the first control line part and the second control line part are twisted together and extend to the region on the rear surface through the one through hole.
[9] The power semiconductor module according to [7], further including a tubular electromagnetic shield disposed to surround the first control line part and the second control line part between the second electrode and control electrode and an opening of the one through hole on the front surface, and including a shielding layer formed from a material having at least one of electrical conductivity and magnetism.
[10] The power semiconductor module according to [7],
   wherein the first control line part and the second control line part include a common mode filter or a transformer capable of removing a common mode component of conductive noise conducted through the first control line part and the second control line part, and
   wherein the common mode filter or the transformer is disposed inside the one through hole.
[11] The power semiconductor module according to any one of [1] to [6],
   wherein the heat sink includes, as the through hole, a first through hole and a second through hole formed at different positions on the front surface,
   wherein the first control line part extends to the region on the rear surface through the first through hole, and
   wherein the second control line part extends to the region on the rear surface through the second through hole.
[12] A power conversion apparatus including:
   a power conversion part including the power semiconductor module according to any one of [1] to [11], and configured to convert a first mode of electric power provided by a power source into a second mode of electric power required by a load device; and
   a control part configured to transmit the control signal to the power semiconductor module.

### Reference Signs List

1 Power conversion apparatus
2 Switching circuit (power conversion part)
3 Control board (control part)
5, 5A, 5B, 5C, 5D, 5E, 5F Power semiconductor module
10, 10A, 10B, 10C, 10D, 10E, 10F Power semiconductor element
11 Drain electrode (first electrode)
12 Source electrode (second electrode)
13 Gate electrode (control electrode)
20, 20A Casing
21, 21A Heat sink
21a Front surface
21b Rear surface
21c, H10 Through hole
22 Cover
22a Top plate
22b Side plate (side wall)
41 First power line part
41P Portion
42 Second power line part
42P Portion (facing portion)
43 First control line part
43P First extension part
44 Second control line part
44P Second extension part
50 Electromagnetic shield
60 Common mode filter
70 Transformer
B Power source
E1 Control signal
E2 Electric power
H11 First through hole
H12 Second through hole
M Load device
N Radiated noise
R1, R2 Region
d1 Extension direction
d2 Direction

## Claims

1. A power semiconductor module comprising:
a power semiconductor element including a first electrode, a second electrode, and a control electrode, and configured to alternately switch conduction and non-conduction between the first electrode and the second electrode according to a control signal applied to the control electrode;
a heat sink including a front surface on which the power semiconductor element is installed and a rear surface opposite the front surface, and capable of dissipating heat from the power semiconductor element;
a first power line part and a second power line part electrically connected to the first electrode and the second electrode, respectively, and configured to transmit electric power between the first electrode and the second electrode;
a first control line part electrically connected to the control electrode and configured to apply the control signal to the control electrode; and
a second control line part electrically connected to the second electrode and configured to provide a reference potential of the control signal,
wherein the heat sink includes a shielding layer formed from a material having at least one of electrical conductivity and magnetism,
wherein the heat sink includes at least one through hole passing from the front surface to the rear surface, and
wherein only the first control line part and the second control line part among the first power line part, the second power line part, the first control line part, and the second control line part extend to a region on the rear surface of the heat sink through the through hole.

2. The power semiconductor module according to claim 1,
wherein the first control line part includes a first monotonically increasing region extending from a cross-section of the through hole, a distance between the first monotonically increasing region and the first power line part and second power line part increasing monotonically in a direction from the control electrode toward the through hole, and
wherein the second control line part includes a second monotonically increasing region extending from a cross-section of the through hole, a distance between the second monotonically increasing region and the first power line part and second power line part increasing monotonically in a direction from the second electrode toward the through hole.

3. The power semiconductor module according to claim 1, comprising a cover covering the front surface of the heat sink on which the power semiconductor element is placed,
wherein the first power line part and the second power line part extend toward the cover from the first electrode and the second electrode, and extend to an outside of a region covered by the cover through the cover.

4. The power semiconductor module according to claim 3,
wherein the cover includes a side wall and a top plate facing the front surface with the side wall interposed therebetween, and
wherein the first power line part and the second power line part extend toward the top plate from the first electrode and the second electrode, and extend to the outside of the region covered by the cover through the top plate.

5. The power semiconductor module according to claim 1,
wherein the first electrode is disposed to face the front surface, wherein the second electrode and the control electrode are disposed on a side of the first electrode opposite to the front surface, and
wherein the at least one through hole is formed at a position not overlapping the second electrode and the control electrode in plan view of the heat sink.

6. The power semiconductor module according to claim 1,
wherein the second electrode and the control electrode are disposed to face the front surface,
wherein the first electrode is disposed on a side of the second electrode and the control electrode opposite to the front surface, and
wherein the at least one through hole is formed at a position overlapping the second electrode and the control electrode in plan view of the heat sink.

7. The power semiconductor module according to claim 1,
wherein the heat sink includes one through hole, and
wherein the first control line part and the second control line part extend to the region on the rear surface through the one through hole.

8. The power semiconductor module according to claim 7, wherein the first control line part and the second control line part are twisted together and extend to the region on the rear surface through the one through hole.

9. The power semiconductor module according to claim 7, further comprising a tubular electromagnetic shield disposed to surround the first control line part and the second control line part between the second electrode and control electrode and an opening of the one through hole on the front surface, and including a shielding layer formed from a material having at least one of electrical conductivity and magnetism.

10. The power semiconductor module according to claim 7,
wherein the first control line part and the second control line part include a common mode filter or a transformer capable of removing a common mode component of conductive noise conducted through the first control line part and the second control line part, and
wherein the common mode filter or the transformer is disposed inside the one through hole.

11. The power semiconductor module according to claim 1,
wherein the heat sink includes, as the through hole, a first through hole and a second through hole formed at different positions in the front surface,
wherein the first control line part extend to the region on the rear surface through the first through hole, and
wherein the second control line part extend to the region on the rear surface through the second through hole.

12. A power conversion apparatus comprising:
a power conversion part including the power semiconductor module according to any one of claims 1 to 11, and configured to convert a first mode of electric power provided by a power source into a second mode of electric power required by a load device; and
a control part configured to transmit the control signal to the power semiconductor module.
